(19) Europäisches Patentamt
European Patent Office
Office européen des brevets

(11) **EP 2 089 560 B1**

(12) **FASCICULE DE BREVET EUROPEEN**

(45) Date de publication et mention
de la délivrance du brevet:
**16.03.2011 Bulletin 2011/11**

(21) Numéro de dépôt: **07858599.9**

(22) Date de dépôt: **16.10.2007**

(51) Int Cl.:
*C23C 16/02* ^(2006.01)    *C23C 16/26* ^(2006.01)

(86) Numéro de dépôt international:
**PCT/FR2007/052173**

(87) Numéro de publication internationale:
**WO 2008/047044 (24.04.2008 Gazette 2008/17)**

(54) **PIECE EN CONTACT GLISSANT, EN REGIME LUBRIFIE, REVETUE D'UNE COUCHE MINCE**

MIT DÜNNFILM BESCHICHTETER GLEITFÜGEPARTNER IN EINEM GESCHMIERTEN SYSTEM

SLIDING MATING PART IN LUBRICATED REGIME, COATED BY A THIN FILM

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **20.10.2006 FR 0654415**

(43) Date de publication de la demande:
**19.08.2009 Bulletin 2009/34**

(73) Titulaire: **H.E.F.**
**42160 Andrézieux-Bouthéon (FR)**

(72) Inventeurs:
• **MAURIN-PERRIER, Philippe**
**42680 Saint Marcellin En Forez (FR)**
• **LEDRAPPIER, Florent**
**42100 Saint Etienne (FR)**
• **HOUZE, Laurent**
**42000 Saint Etienne (FR)**

(74) Mandataire: **Thivillier, Patrick et al**
**Cabinet Laurent & Charras**
**3 Place de l'Hôtel de Ville**
**B.P. 203**
**42005 Saint-Etienne Cedex 1 (FR)**

(56) Documents cités:
**EP-A2- 1 207 314    WO-A-01/79585**
**WO-A-03/091474**

**Description**

L'invention concerne le domaine technique de la tribologie en milieu lubrifié.

Plus particulièrement, l'invention concerne les revêtements et les traitements de surface destinés à réduire l'usure et à minimiser la transmission des efforts tangentiels.

De nombreuses solutions techniques ont été proposées pour améliorer les performances tribologiques des pièces mécaniques. On distingue essentiellement les traitements traditionnels de durcissement superficiel et les dépôts de couches minces et dures obtenues par différents procédés tels que le procédé PVD (Physical Vapour Déposition) ou le procédé PACVD (Plasma Assisted Chemical Vapour Déposition).

Parmi les dépôts de couches minces et dures, on peut citer les dépôts de nitrures de métaux de transition (TiN, CrN, TiAlN, ...), les revêtements de carbone amorphe (DLC)... Pour des raisons techniques, mais aussi mécaniques, il ressort que ces dépôts de revêtement de surface n'excèdent généralement pas 5 $\mu$m. Au-delà de cette épaisseur, peuvent apparaître des risques de fragilisation de la couche et d'écaillage. Il est également important d'obtenir une parfaite adhérence et une tenue dans le temps de la couche mince. Ainsi, l'homme de métier revendique des états de surface très peu accidentés avec une rugosité (Ra) de l'ordre de 0,04 $\mu$m.

Il ressort donc de l'état de la technique que les performances tribologiques des traitements de surfaces et des dépôts sous vide, ne sont assurées qu'à condition d'avoir des surfaces de faible rugosité.

On peut citer par exemple l'enseignement du brevet US 6,886,521 qui pose une valeur maximale du paramètre de rugosité de surface (Rz) en fonction de la dureté du dépôt de DLC et de l'épaisseur de celui-ci. L'homme du métier revendique généralement des rugosités les plus faibles possibles soit, par exemple, Ra $\leq$ 0,04 $\mu$m.

Ainsi, il ressort de l'analyse de l'état de la technique que des rugosités de surface élevées ne sont pas adaptées pour recevoir des dépôts durs étant donné qu'il en résulte des effets d'irrégularités de surface conduisant à des surpressions locales pouvant provoquer des déformations plastiques excessives néfastes à la tenue mécanique du revêtement. En outre, en régime lubrifié, lorsque l'amplitude des aspérités est trop importante. Le film d'huile est localement rompu et les surfaces qui sont en mouvement relatif, ne sont plus parfaitement séparées, ce qui conduit à une élévation du coefficient de frottement et une usure prématurée desdites surfaces.

Des publications scientifiques dans le domaine de la tribologie, évoquent également l'influence de la rugosité sur la lubrification. On peut citer, par exemple :

« Occurrence of microelastohydrodynamic lubrication in simple sliding motion with transverse roughness" - J. Wang, M. Kaneta, F. Guo, P. Yang - Journal of Engineering Tribology - Vol. 220 N° J 13 (may 2006) pp. 273-285.

Il ressort de ces publications qu'il convient de considérer l'amplitude des aspérités de surface et d'en conclure qu'il convient de rechercher les rugosités les plus faibles possibles en vue de diminuer le coefficient de frottement.

A noter également, comme il ressort de la publication scientifique : « Influence of harmonic surface roughness on the fatigue life of elastohydrodynamic lubricated contact » - A.D. Chapkov, F. Colin, A. A. Lubrecht - Journal of Engineering Tribology - Vol. 220 N° J 13 (may 2006) pp.287-294", qu'une l'analyse numérique du contact de surface rugueuse assimilée à des profils sinusoïdaux, révèle des effets de surpression liés aux irrégularités des surfaces en contact, et indique que ces surpressions peuvent être limitées en augmentant la période de profil. Toutefois, cette diminution de la pression de contact sur des profils à grande longueur d'onde, s'explique par une déformation élastique du substrat. Dans le cas de dépôts durs obtenus par procédé PVD ou PACVD, ces dépôts, compte tenu de leur module d'élasticité élevé et leur grande dureté, s'accommodent mal de la déformation du substrat, de sorte qu'ils seront rapidement endommagés.

Il ressort donc clairement de l'état de la technique, dans le domaine de la tribologie, que les dépôts de couches minces, par exemple dans le cas de carbone amorphe, doivent être effectués sur des surfaces présentant des niveaux de finition très élevés avec une rugosité (Ra) ne dépassant pas quelques centièmes de microns et généralement inférieure à 0,04 $\mu$m.

D'une manière surprenante et inattendue et à l'encontre des connaissances générales de l'homme du métier, il est apparu qu'un état de surface présentant une certaine rugosité, avec une période suffisamment grande, peut permettre des dépôts minces obtenus par un procédé PVD ou PACVD, et cela lorsque les pièces travaillent en régime lubrifié.

Il en résulte donc, selon une caractéristique à la base de l'invention, que la couche mince est déposée sur une surface présentant des profils de rugosité dont les paramètres et les périodes moyennes sont déterminés pour améliorer les performances tribologiques. L'obtention de ces profils de rugosité particuliers s'effectue en choisissant des paramètres d'usinage (tournage, fraisage) appropriés (vitesse de rotation de la broche, avance de l'outil, ...)

Plus particulièrement, selon une caractéristique à la base de l'invention, le rapport A entre le carré de la période moyenne du profil ($P_{SM}$) en $\mu$m et le profil de rugosité (Pa) en $\mu$m, tels que définis par la norme française ISO 4288 est supérieur ou égal à $5.10^5$ $\mu$m, soit :

$$A = \frac{P_{SM}^{2}}{Pa} \geq 5.10^{5} \ \mu m$$

En raison de la forte dispersion des paramètres ($P_{SM}$), cette formule s'appliquera à des paramètres moyens calculés à partir de 8 mesures réalisées au niveau de la zone frottante et parallèlement à la direction du glissement.

Des essais tribologiques ont notamment donné des résultats remarquables à partir de (A) supérieur à $10^{6}$ $\mu m$ et encore meilleurs à partir de (A) supérieur à $10^{7}$ $\mu m$.

Il est par conséquent possible de tolérer des états de surface parfois fortement dégradés, avec une hauteur de profil habituellement non tolérée en jouant uniquement sur la période des ondulations.

L'application de la formule précédente, pour un profil présentant une rugosité (Pa) de 0,4 $\mu m$ montre que de bons résultats sont obtenus lorsque la période moyenne de ce profil ($P_{SM}$) est supérieure à 450 $\mu m$. Des résultats encore meilleurs sont obtenus lorsque la période moyenne de ce profil ($P_{SM}$) est supérieure à 2 mm.

Compte tenu des caractéristiques à la base de l'invention, contrairement à l'enseignement de l'état de la technique, où il était nécessaire d'obtenir un état de surface avec des niveaux de finition élevés, il est possible par conséquent d'obtenir, à moindre coût, des pièces aux performances tribologiques équivalentes, voire supérieures.

Ainsi, lorsqu'il n'est pas possible, pour des raisons économiques ou techniques, d'obtenir des états de surface remarquables par des procédés de rodage, rectification ou autre, selon l'invention, il suffit de dégrossir sommairement la surface, de manière à limiter la présence des arêtes vives et des pics de rugosité en ne conservant que les ondulations de surface liées aux procédés d'usinage amont. Ces derniers seront même optimisés (vitesse de rotation, avance de l'outil, ...), afin de maximiser le paramètre (A) défini plus haut. Ces ondulations permettent d'obtenir un profil sinusoïdal acceptable au niveau de la lubrification qui s'avère intéressant en vue de réduire les coûts de fabrication pour des applications de marché de grande série.

A noter que les procédés d'obtention de grande période sur les motifs de rugosité sont multiples et généralement facilement réalisables à partir de procédés d'usinage conventionnels : tournage, fraisage, ...

On renvoie au tableau ci-après qui montre différents exemples de traitement selon l'invention. Les pièces ou échantillons sont des éprouvettes d'essais planes obtenues par différents procédés d'usinage, de manière à observer l'influence de la préparation de surface et le coefficient de frottement au cours d'un essai en régime lubrifié. Les surfaces ont été revêtues d'un dépôt de DLC réalisé par le procédé PACVD. Les échantillons ont été testés en régime lubrifié dans un bain d'huile 5W30 chauffée à 100°C face à une bague en acier 100C6 non traitée tournant à vitesse constante. Le coefficient de frottement de la bague face à l'échantillon a été mesuré au cours des essais. Quatre échantillons (A), (B), (C), (D) ont été réalisés en vue de comparer leur coefficient de frottement.

| Echantillon | $R_a$ ($\mu m$) | $R_z$ ($\mu m$) | $P_a$ ($\mu m$) | $P_{SM}$ ($\mu m$) | $A = P_{SM}^{2}/Pa$ ($\mu m$) | Coefficient de frottement | Surface dégradée ($mm^2$) |
|---|---|---|---|---|---|---|---|
| A | 0.014 | 0.12 | 0.18 | 240 | $3.10^{5}$ | 0.089 | 2.9 |
| B | 0.042 | 0.25 | 0.23 | 1300 | $7.10^{6}$ | 0.087 | 1.0 |
| C | 0.036 | 0.20 | 0.23 | 2400 | $2.5.10^{7}$ | 0.065 | 0.6 |
| D | 0.12 | 0.79 | 0.34 | 578 | $10^{6}$ | 0.088 | 2.1 |

Ces résultats démontrent que le rapport A défini plus haut influence d'avantage le coefficient de frottement que les paramètres de rugosité (Ra) et (Rz). On observe, par exemple, que l'échantillon (A), malgré une rugosité très faible, ne rentre pas dans le domaine de l'invention et présente un coefficient de frottement le plus élevé de ce tableau. Au contraire, l'échantillon (C), bien qu'il présente un (Ra) nettement supérieur à celui de l'échantillon (A), présente un rapport A très élevé et présente un comportement en frottement faible.

Les avantages ressortent bien de la description.

L'invention trouve des applications avantageuses dans le domaine de l'automobile, notamment dans le cas de pièces en frottement dans le moteur.

**Revendications**

1. Pièce en contact glissant, en régime lubrifié, revêtue d'une couche mince, par exemple de carbone amorphe (DLC), à fonction tribologique, **caractérisée en ce que** la couche mince est déposée sur une surface présentant des profils de rugosité dont les paramètres et les périodes moyennes sont déterminés pour améliorer les performances tribologiques, de sorte que le rapport A entre le carré de la période moyenne du profil ($P_{SM}$) en $\mu$m et le profil de rugosité (Pa) en $\mu$m, tels que définis par la norme française ISO 4288, est supérieur ou égal à $5.10^5$ $\mu$m, soit :

$$A = \frac{P_{SM}^{2}}{Pa} \geq 5.10^5 \ \mu m$$

**2.** Pièce selon la revendication 2, **caractérisée en ce que** le rapport A est supérieur à $10^6$ $\mu$m.

**3.** Pièce selon la revendication 2, **caractérisée en ce que** le rapport A est supérieur à $10^7$ $\mu$M.

**4.** Pièce selon la revendication 1, **caractérisée en ce que**, pour un profil dont la rugosité Pa est de l'ordre de 0,4 $\mu$m, la période moyenne dudit profil $P_{SM}$ est supérieure à 450 $\mu$m.

**5.** Pièce selon la revendication 1, **caractérisée en ce que**, pour un profil dont la rugosité Pa est de l'ordre de 0,4 $\mu$m, la période moyenne dudit profil $P_{SM}$ est supérieure à 2 mm.

**6.** Utilisation de pièces selon l'une quelconque des revendications 1 à 5 dans le domaine de l'automobile notamment des parties constitutives d'un moteur.

**Claims**

**1.** Sliding mating part in lubricated regime, coated with a thin film of, for example, amorphous (DLC) carbon, with a tribological function, **characterized in that** the thin film is deposited on a surface that has roughness profiles whereof the parameters and average periods are determined so as to improve tribological performance, so that the ratio A between the square of the average period of the profile ($P_{SM}$) in $\mu$m and the roughness profile (Pa) in $\mu$m, as defined in French standard ISO 4288, is greater than or equal to $5.10^5$ $\mu$m, i.e.:

$$A = \frac{P_{SM}^{2}}{Pa} \geq 5.10^5 \ \mu m$$

**2.** Part as claimed in claim 2, **characterized in that** the ratio A is greater than 1 06 $\mu$m.

**3.** Part as claimed in claim 2, **characterized in that** the ratio A is greater than $10^7$ $\mu$m.

**4.** Part as claimed in claim 1, **characterized in that**, for a profile whereof the roughness Pa is of the order of 0.4 $\mu$m, the average period of said profile $P_{SM}$ is greater than 450 $\mu$m.

**5.** Part as claimed in claim 1, **characterized in that**, for a profile whereof the roughness Pa is about 0.4 $\mu$m, the average period of said profile $P_{SM}$ is greater than 2 mm.

**6.** Use of parts as claimed in any one of claims 1 to 5 in the field of car manufacture and particularly of the component parts of an engine.

**Patentansprüche**

**1.** Gleitpartner in einem geschmierten System, der mit einem Dünnfilm mit tribologischer Funktion, beispielsweise aus amorphem Kohlenstoff (DLC), beschichtet ist,
**dadurch gekennzeichnet, dass** der Dünnfilm auf eine Fläche mit Rauigkeitsprofilen aufgetragen wird, deren Parameter und mittlere Breiten so ausgelegt sind, um die tribologischen Leistungen zu verbessern, dergestalt dass das Verhältnis A zwischen dem Quadrat der mittleren Breite des Profils ($P_{SM}$) in $\mu$m und dem Rauigkeitsprofil (Pa)

in μm - wie von der französischen Norm ISO 4288 definiert - größer oder gleich 5.10$^5$ μm ist, d. h.:

$$A = \frac{P_{SM}^2}{Pa} \geq 5.10^5 \ \mu m$$

2.  Gleitpartner nach Anspruch 2, **dadurch gekennzeichnet, dass** das Verhältnis A größer als 10$^6$ μm ist.

3.  Gleitpartner nach Anspruch 2, **dadurch gekennzeichnet, dass** das Verhältnis A größer als 10$^7$ μm ist.

4.  Gleitpartner nach Anspruch 1, **dadurch gekennzeichnet, dass** bei einem Profil mit der Rauigkeit Pa von 0,4 μm die mittlere Profilbreite $P_{SM}$ größer als 450 μm ist.

5.  Gleitpartner nach Anspruch 1, **dadurch gekennzeichnet, dass** bei einem Profil mit der Rauigkeit Pa von 0,4 μm die mittlere Profilbreite $P_{SM}$ größer als 2 mm ist.

6.  Verwendung von Gleitpartnern nach einem der Ansprüche 1 - 5 im Automobilbereich, insbesondere für die Bestandteile eines Motors.

# EP 2 089 560 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6886521 B

**Littérature non-brevet citée dans la description**

- **J. Wang ; M. Kaneta ; F. Guo ; P. Yang.** Occurrence of microelastohydrodynamic lubrication in simple sliding motion with transverse roughness. *Journal of Engineering Tribology,* Mai 2006, vol. 220 (J 13), 273-285

- **A.D. Chapkov ; F. Colin ; A. A. Lubrecht.** Influence of harmonic surface roughness on the fatigue life of elastohydrodynamic lubricated contact. *Journal of Engineering Tribology,* Mai 2006, vol. 220 (J 13), 287-294